# EUROPEAN PATENT APPLICATION

(11) **EP 4 451 314 A1**
(43) Date of publication of application: **23.10.2024**
(21) Application number: 22906882.0
(22) Date of filing: 11.03.2022
(51) Int. Cl.: H01L 21/304

(54) **SEMICONDUCTOR CRYSTAL WAFER MANUFACTURING DEVICE AND MANUFACTURING METHOD**

(30) Priority: 14.12.2021 JP 2021202679
(71) Applicant: Success Co., Ltd., Noda-shi Chiba 278-0022 (JP); Drychemicals Co., Ltd., Natori-shi, Miyagi 981-1238 (JP)
(72) Inventor: SAKAI Shinsuke, Noda-shi, Chiba 278-0022 (JP); CHIBA Tetsuya, Natori-shi, Miyagi 981-1238 (JP)
(74) Representative: Papula Oy
(86) International application number: PCT/JP2022/010959
(87) International publication number: WO 2023/112345

(57) **Abstract**

The purpose of the present invention is to provide a device and a method for manufacturing semiconductor crystal wafer, the device and the method being capable of easily and reliably manufacture semiconductor crystal wafers of high-quality. This manufacturing method for a SiC wafer, being a semiconductor crystal wafer, comprises: a pad groove formation step (STEP10/FIG.1) and a bobbin groove formation step (STEP20/FIG.1) prior to a groove machining step (STEP100/FIG.1), and after the groove machining step (STEP100/FIG.1), a polishing step (STEP110/FIG.1), a cutting step (STEP120/FIG.1), a first surface machining step (STEP130/FIG.1), and a second surface machining step (STEP140/ FIG.1).

## Description

### TECHNICAL FIELD

The present invention relates to a method and a device for manufacturing semiconductor crystal wafer, which cut a semiconductor crystal ingot, that has been ground into a cylindrical shape, into slices as wafers.

### BACKGROUND ART

Conventionally, as for the manufacturing method of SiC wafer of such semiconductor crystal wafer, as shown in the following Patent Document 1, it is known to include a wafer shape forming step, followed by a process-affected layer removal step, and finally a mirror polishing step. The wafer shape forming step includes: an ingot forming step, in which a single crystal SiC block grown by crystallization is processed into a cylindrical ingot; a crystal orientation forming step, in which a notch is formed on a part of the outer periphery of the ingot to become a mark showing a crystal orientation of the ingot; a slicing step, in which the single crystal SiC ingot is sliced into thin disc-shaped SiC wafers; a planarization step, in which the SiC wafers are planarized by using abrasive grains that do not reach the modified Mohs hardness; a mark forming step of forming a mark; and a chamfering step of chamfering the outer peripheral portion. In the process-affected layer removal step, the process-affected layer introduced into the SiC wafer in the previous steps is removed. The mirror polishing step is a chemical mechanical polishing (CMP) step uses both the mechanical action of a polishing pad and the chemical action of slurry to perform polishing.

### [Citation List]

### [Patent Literature]

Patent Document 1: JP2020015646 A

### SUMMARY OF INVENTION

### [Technical Problem]

However, the above-mentioned conventional method for manufacturing a SiC wafer has the problems of multiple and complex manufacturing processes, complex device structure, and high manufacturing cost.

On the other hand, if the process is simplified, it is difficult to stably obtain the required quality for SiC wafers.

In view of this, an object of the present disclosure is to provide a device and a method for manufacturing a semiconductor crystal wafer that can easily and reliably manufacture high-quality semiconductor crystal wafers.

### [Solution to Problem]

A semiconductor crystal wafer manufacturing device of the first invention is a device for manufacturing a semiconductor crystal wafer, which cuts a semiconductor crystal ingot, that has been ground into a cylindrical shape, into slices as wafers, the device comprising:
a groove machining drum grindstone configured for forming a plurality of concave grooves surrounding an entire side surface of said semiconductor crystal ingot, wherein a plurality of convex portions corresponding to the plurality of concave grooves are formed on a side surface of the groove machining drum grindstone;
a polishing pad being cylindrical and configured for polishing the plurality of concave grooves, wherein a plurality of pad grooves corresponding to said plurality of convex portions are formed on an entire side surface of the polishing pad; and
a wire saw device for revolving a plurality of wires arranged in said plurality of concave grooves while advancing the plurality of wires, thereby cutting said semiconductor crystal ingot into slices, and an entire side surface of a wire saw bobbin for revolving the plurality of wires is formed with bobbin grooves corresponding to said plurality of convex portions.

According to the semiconductor crystal wafer manufacturing device of the first invention, (1) the manufacturing device is composed of a total of three members, that is, a groove machining drum grindstone and two additional members corresponding to the groove machining drum grindstone, wherein the groove machining drum grindstone forms a plurality of concave grooves surrounding an entire side surface of the semiconductor crystal ingot, and a plurality of convex portions corresponding to the plurality of concave grooves are formed on a side surface of the groove machining drum grindstone.

(2) The first member of the additional members is a cylindrical polishing pad used to polish the plurality of grooves formed on the entire side surface of the semiconductor crystal ingot, and a plurality of pad grooves corresponding to the plurality of convex portions are formed on an entire side surface of the polishing pad.

(3) The second member of the additional members is a wire saw device for revolving a plurality of wires arranged in the plurality of grooves formed on the entire side surface of the semiconductor crystal ingot, and bobbin grooves corresponding to the plurality of convex portions are formed on an entire side surface of a wire saw bobbin.

Moreover, due to the above (1) groove machining drum grindstone, (2) polishing pad, (3) and wire saw device have corresponding concave and convex groove shapes, (1) with respect to a plurality of concave grooves formed on the entire side surface of the semiconductor crystal ingot by the groove machining drum grindstone, (2) polishing along the concave grooves can be performed with the polishing pad having exactly the same pitch, and (3) by the wires revolved via the wire saw bobbin having the same shape as the concave grooves, the semiconductor crystal ingot can be cut into slices with high precision by using the plurality of wires accurately arranged in the plurality of concave grooves.

In addition, since the edges of the semiconductor wafers obtained by cutting into slices are evenly chamfered in the corner portions by the polishing pad with exactly the same pitch, there is no need to perform chamfering machining after cutting.

Therefore, according to the semiconductor crystal wafer manufacturing device of the first invention, the semiconductor crystal ingot can be cut into slices with high precision, so as to simply and reliably manufacture a high-quality semiconductor crystal wafer.

The semiconductor crystal wafer manufacturing device of the second invention is that, the manufacturing device in the first invention is provided with a pair of protective plates, wherein the pair of protective plates protect both end surfaces of the semiconductor crystal ingot at least when the plurality of concave grooves surrounding the entire side surface of the semiconductor crystal ingot are formed by said groove machining drum grindstone.

The semiconductor crystal wafer manufacturing device of the second invention is provided with a pair of protective plates, wherein the pair of protective plates protect both end surfaces of the semiconductor crystal ingot at least when the plurality of concave grooves surrounding the entire side surface of the semiconductor crystal ingot are formed by said groove machining drum grindstone.

Thereby, the pair of protective plates can protect both ends of the semiconductor crystal ingot and prevent chipping and cracking of both ends. Therefore, a plurality of concave grooves can be formed close to end edges of both end surfaces, so that a larger amount of cutting can be performed to obtain a larger amount of semiconductor crystal wafers.

In this way, according to the semiconductor crystal wafer manufacturing device of the second invention, the semiconductor crystal ingot can be cut into more slices with high accuracy, so as to enable high-quality semiconductor crystal wafers to be manufactured efficiently, simply and reliably.

A semiconductor crystal wafer manufacturing method of the third invention is a method for manufacturing a semiconductor crystal wafer, which cuts a semiconductor crystal ingot, that has been ground into a cylindrical shape, into slices as wafers, the method comprising:
a groove machining step for forming a plurality of concave grooves surrounding an entire side surface of said semiconductor crystal ingot; and
a cutting step for revolving a plurality of wires arranged in the plurality of concave grooves formed in said groove machining step while advancing the plurality of wires, thereby cutting said semiconductor crystal ingot into slices;
the method performing the following steps before said groove machining step:
   a pad groove formation step for forming a plurality of pad grooves corresponding to the plurality of convex portions on an entire side surface of a cylindrical polishing pad by using a groove machining drum grindstone, wherein a plurality of convex portions corresponding to said plurality of concave grooves are formed on a side surface of the groove machining drum grindstone, wherein the groove machining drum grindstone is used by being pressed against the semiconductor crystal ingot in said groove machining step, and the polishing pad is used to polish said plurality of concave grooves formed by the groove machining step; and
   a bobbin groove formation step for forming bobbin grooves corresponding to said plurality of convex portions on an entire side surface of a wire saw bobbin which revolves the plurality of wires and is used in said cutting step, by using the groove machining drum grindstone to be used by being pressed against the semiconductor crystal ingot in said groove machining step;
   wherein, in said groove machining step, said groove machining drum grindstone is pressed against said semiconductor crystal ingot while the groove machining drum grindstone and the semiconductor crystal ingot respectively rotating on rotation shafts parallel to each other, thereby forming the concave grooves, and the polishing pad which is formed with the pad grooves by said pad groove formation step, and is pressed against said semiconductor crystal ingot while the polishing pad and the semiconductor crystal ingot respectively rotating on rotation shafts parallel to each other, thereby polishing the concave grooves;
   in said cutting step, said semiconductor crystal ingot is cut into slices by a wire saw having wires respectively arranged in the plurality of bobbin grooves formed by said bobbin groove formation step.

According to the semiconductor crystal wafer manufacturing method of the third invention, (1) before the groove machining step of forming concave grooves corresponding to the plurality of convex portions of the groove machining drum on the entire side surface of the semiconductor crystal ingot, the following two steps are first performed by using the groove machining drum (plural convex portions).

First, the first step is (2) forming a plurality of pad grooves corresponding to the plurality of convex portions on the entire side surface of the cylindrical polishing pad by the pad groove formation step, wherein the polishing pad is used to polish a plurality of concave grooves formed on the entire side surface of the semiconductor crystal ingot.

The second step is (3) by the bobbin groove formation step, bobbin grooves corresponding to the plurality of convex portions are formed on the entire side of the wire saw bobbin which revolves the plurality of wires and is used in the cutting step.

Moreover, due to these (1) groove machining drum grindstone, (2) polishing pad, (3) and wire saw device have corresponding concave and convex groove shapes, (1) with respect to the plurality of concave grooves formed on the entire side surface of the semiconductor crystal ingot by using the groove machining drum grindstone in the groove machining step, (2) polishing along the concave grooves can be performed with the polishing pad having exactly the same pitch in the polishing step, and (3)by the wires revolved via the wire saw bobbin having the bobbin grooves having the same shape as the concave grooves, the semiconductor crystal ingot can be cut into slices with high precision by using the plurality of wires accurately arranged in the plurality of concave grooves in the cutting step.

In addition, since the edges of the semiconductor wafers obtained by cutting into slices are evenly chamfered in the corner portions by the polishing pad with exactly the same pitch, there is no need to perform chamfering machining after cutting.

Therefore, according to the semiconductor crystal wafer manufacturing method of the third invention, the semiconductor crystal ingot can be cut into slices with high precision, so as to simply and reliably manufacture a high-quality semiconductor crystal wafer.

The semiconductor crystal wafer manufacturing method of the fourth invention is that, in said pad groove formation step in the third invention, said groove machining drum grindstone is pressed against an entire side surface of a cylindrical pad groove machining grindstone to form pad machining grooves corresponding to said plurality of convex portions, and bring said pad groove machining grindstone, in which said pad machining grooves are formed, is pressed against the entire side surface of said polishing pad to form a plurality of pad grooves corresponding to said plurality of convex portions.

According to the semiconductor crystal wafer manufacturing method of the fourth invention, in the pad groove formation step, a pad groove machining grindstone in which pad machining grooves corresponding to the plurality of convex portions are formed is prepared in advance. Furthermore, the pad groove machining grindstone is pressed against the entire side surface of the polishing pad to form a plurality of pad grooves corresponding to the pad machining grooves, thereby allowing the pad grooves and the plurality of convex portions of the groove machining drum grindstone to have the same shape.

Thereby, in the polishing step, the concave grooves can be polished by using a polishing pad with a plurality of pad grooves that are completely consistent with the plurality of concave grooves.

Therefore, according to the semiconductor crystal wafer manufacturing method of the fourth invention, the grindability can be improved, the semiconductor crystal ingot can be cut into slices with high precision, so as to simply and reliably manufacture a high-quality semiconductor crystal wafer.

The semiconductor crystal wafer manufacturing method of the fifth invention is that, in the third invention or the fourth invention, said semiconductor crystal ingot is rotatably supported through a pair of protective plates that protect both end surfaces of the semiconductor crystal ingot at least during said groove machining step.

According to the semiconductor crystal wafer manufacturing method of the fifth invention, said semiconductor crystal ingot is rotatably supported through a pair of protective plates that protect both end surfaces of the semiconductor crystal ingot at least during said groove machining step, which forms the plurality of concave grooves on the entire side surface of the semiconductor crystal ingot.

Thereby, the pair of protective plates can protect both ends of the semiconductor crystal ingot and prevent chipping and cracking of both ends. Therefore, a plurality of concave grooves can be formed close to end edges of both end surfaces, so that a larger amount of cutting can be performed to obtain a larger amount of semiconductor crystal wafers.

In this way, according to the semiconductor crystal wafer manufacturing method of the fifth invention, the semiconductor crystal ingot can be cut into more slices with high accuracy, so as to enable high-quality semiconductor crystal wafers to be manufactured efficiently, simply and reliably.

### BRIEF DESCRIPTION OF THE DRAWINGS

FIG. 1 is a flowchart showing an entire process of a manufacturing method of a SiC wafer (semiconductor crystal wafer) according to one embodiment.
FIG. 2 is an explanatory diagram showing a manufacturing device of the SiC wafer, which is composed of a pad groove formation step, a bobbin groove formation step and a groove machining step in the SiC wafer manufacturing method in FIG. 1, according to one embodiment.
FIG. 3 is an explanatory diagram showing the contents of the groove machining step, the grinding step and the cutting step in the SiC wafer manufacturing method of FIG. 1.
FIG. 4 is an explanatory diagram showing the contents of a first surface machining step and a second surface machining step in the SiC wafer manufacturing method of FIG. 1.
FIG. 5 is an explanatory diagram showing a modified example of the SiC wafer manufacturing device of FIG. 2.

### DESCRIPTION OF EMBODIMENTS

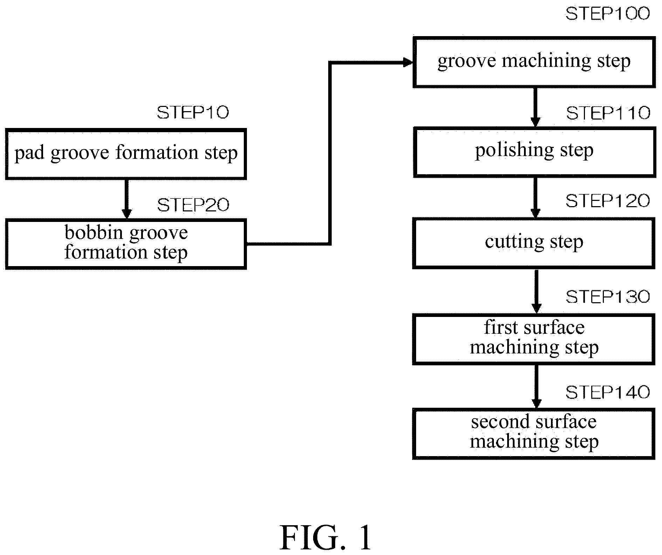

As shown in FIG. 1, in this embodiment, a method for manufacturing a SiC wafer of a semiconductor crystal wafer is a method used to obtain a SiC wafer that is cut into slices from a SiC ingot that has been ground into a cylindrical shape. This manufacturing method includes a pad groove formation step (STEP10/FIG. 1) and a bobbin groove formation step (STEP20/FIG. 1) before a groove machining step (STEP100/FIG. 1), and includes a polishing step (STEP110/FIG. 1), a cutting step (STEP120/FIG. 1), a first surface machining step (STEP130/FIG. 1) and a second surface machining step (STEP140/FIG. 1) that follow the groove machining step (STEP100/FIG. 1).

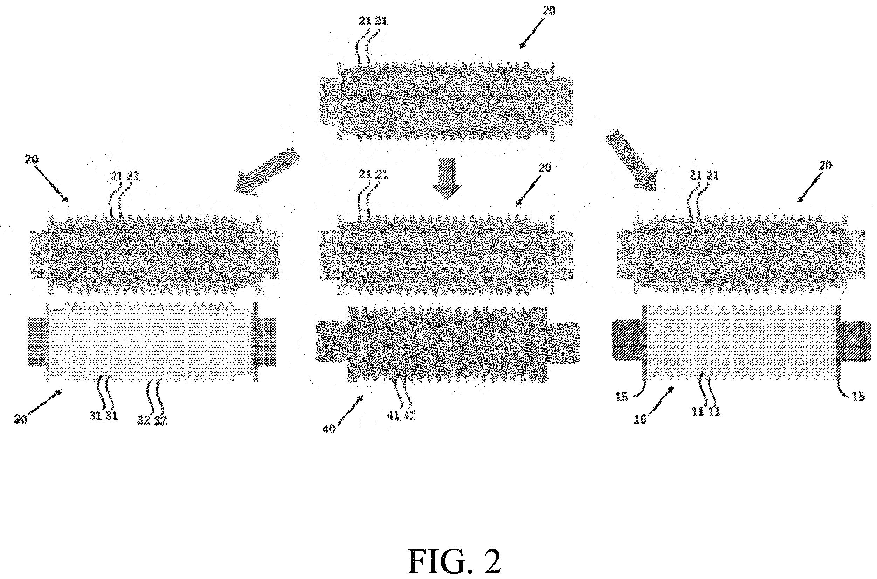

Referring to FIG. 2 to FIG. 4, the details of each step and the SiC wafer manufacturing device of this embodiment will be described.

In the pad groove formation step (STEP10/FIG. 1) and the bobbin groove formation step (STEP20/FIG. 1) shown in FIG. 2, the following process is performed by using a common groove machining drum grindstone 20 used in the groove machining step (STEP100/FIG. 1).

The groove machining drum grindstone 20 is a drum grindstone used to form a plurality of concave grooves 11 surrounding the entire side surface of the SiC ingot 10, and a plurality of convex portions 21 corresponding to the plurality of concave grooves 11 are formed on the side surface of the groove machining drum grindstone 20.

First, in the pad groove formation step (STEP10/FIG. 1), a cylindrical polishing pad 30 for grinding a plurality of concave grooves 11 is processed, in which the groove machining drum grindstone 20 is pressed against the polishing pad 30 while the polishing pad 30 and the groove machining drum grindstone 20 are rotated on rotation shafts parallel to each other. Thereby, a plurality of pad grooves 31 corresponding to the plurality of convex portions 21 are formed on the entire side surface of the polishing pad 30.

At this time, the pad grooves 31 is formed in a state that the polishing pad 30 is frozen and solidified (after being moistened with an appropriate amount of water as necessary). Furthermore, the polishing pad 30 on which the pad grooves 31 are formed is used in the following steps after thawing (and drying if necessary).

Furthermore, in the bobbin groove formation step (STEP20/FIG. 1), a wire saw bobbin 40 for revolving a plurality of wires 42 of a wire saw device 4 used in the cutting step (STEP120/FIG. 1) is processed, in which the groove machining drum grindstone 20 is pressed against the wire saw bobbin 40 while the wire saw bobbin 40 and the groove machining drum grindstone 20 are rotated on rotation shafts parallel to each other. Thereby, a plurality of bobbin grooves 41 corresponding to the plurality of convex portions 21 are formed on the entire side surface of the wire saw bobbin 40.

Here, in this embodiment, the process is performed in the order from the pad groove formation step (STEP10/FIG. 1) to the bobbin groove formation step (STEP20/FIG. 1). However, the process may be performed in the order from the bobbin groove formation step (STEP 20/FIG. 1) to the pad groove formation step (STEP 10/FIG. 1).

Next, in the groove machining step (STEP 100/FIG. 1), a plurality of concave grooves 11 surrounding the entire side surface of the SiC ingot 10 are formed by using the common groove machining drum grindstone 20.

Specifically, in the groove machining step (STEP 100/FIG. 1), while the groove machining drum grindstone 20, which has a plurality of convex portions 21 corresponding to a plurality of concave grooves 11 formed entirely on the side surface, and the SiC ingot 10 are rotated on rotation shafts parallel to each other, the groove machining drum grindstone 20 is pressed aginast the SiC ingot 10 to thereby form the concave grooves 11.

At this time, the SiC ingot 10 is such supported to rotate freely while both end surfaces of the SiC ingot 10 are protected by a pair of protective plates 15, 15.

The protective plate 15 is made of synthetic resin such as polyvinyl chloride, and can be bonded to the SiC ingot 10 via an adhesive as necessary.

The pair of protective plates 15 and 15 can protect both ends of the SiC ingot 10 and prevent chipping and cracking of both ends. Therefore, a plurality of concave grooves 11 can be formed close to end edges of both end surfaces, so that a larger amount of cutting can be performed to obtain a larger amount of SiC wafers 100 described below.

In addition, when the SiC ingot 10 is clamped and fixed onto the rotation shaft, the protective plates 15 and 15 can be processed (e.g., drilled) as needed to fix them. In addition, even in this case, the SiC ingot 10 will not be damaged because the SiC ingot 10 itself is not processed.

The plurality of concave grooves 11 of the SiC ingot 10, the plurality of pad grooves 31 of the polishing pad 30 and the plurality of bobbin grooves 41 of the wire saw bobbin 40 formed by the above processing steps have the same shape corresponding to the plurality of convex portions 21 of the groove machining drum grindstone 20.

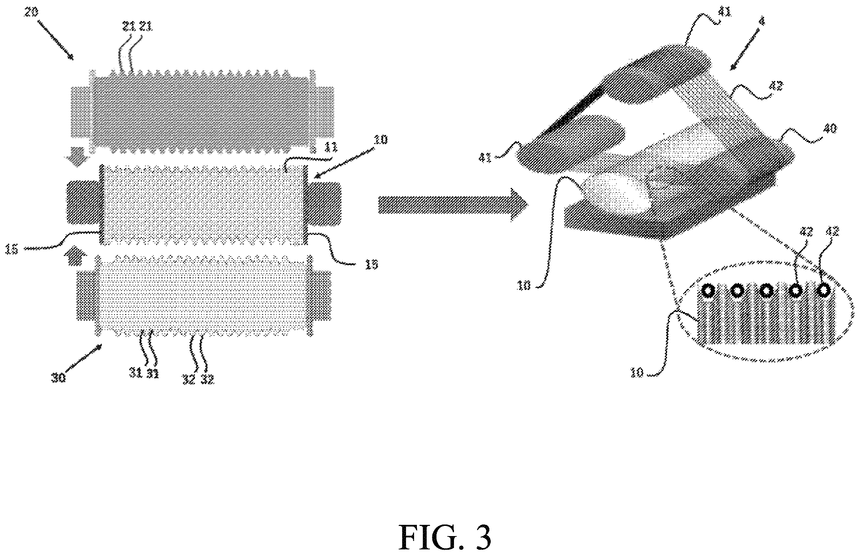

Therefore, as shown in FIG. 3, at approximately the same time as forming a plurality of concave grooves 11 in the SiC ingot 10 in the groove machining step (STEP 100 / FIG. 1), in the polishing step (STEP 110 / FIG. 1), polishing along the concave grooves 11 can be performed by a plurality of pad convex portions 32 (the convex portions between two adjacent pad grooves 31, 31) of the polishing pad 30 having the same pitch as the concave grooves 11.

Here, the polishing step (STEP110/FIG. 1) can be performed by CMP slurry (chemical mechanical liquid abrasive). However, powder abrasive (buffing abrasive) may be added intermittently or continuously to the surface of the polishing pad 30.

Here, when adding powder abrasive (buffing abrasive) to the surface of the polishing pad 30, for example, powder abrasive (buffing abrasive) can be first applied to a buff with the same shape as a pad groove machining grindstone 20' described later, and then the buff is brought into contact to the surface of the polishing pad 30 intermittently or continuously.

Furthermore, in the cutting step (STEP120/FIG. 1), the plurality of wires 42 of the wire saw device 4 as the cutting device are arranged in the plurality of concave grooves 11 formed in the groove machining step (STEP100/FIG. 1), and the wires 42 are advanced while being revolved, whereby the SiC ingot 10 is cut into slices.

At this time, as the wires 42 are revolved via the wire saw bobbin 40 which is formed with the bobbin grooves 11 having the same shape as the plurality of concave grooves 11, the SiC ingot 10 can be cut into slices at once with high precision by using the plurality of wires 42 accurately arranged in the plurality of concave grooves 11.

In addition, since the edges of the SiC wafers 100 obtained by cutting into slices are evenly chamfered in the corner portions by the polishing pad 30 with exactly the same pitch, there is no need to perform chamfering machining after cutting.

Here, regarding the structure of the semiconductor crystal wafer (SiC wafer) manufacturing device (cutting device) of this embodiment, it is constituted by the groove machining drum grindstone 20, the polishing pad 30 and the wire saw device 40.

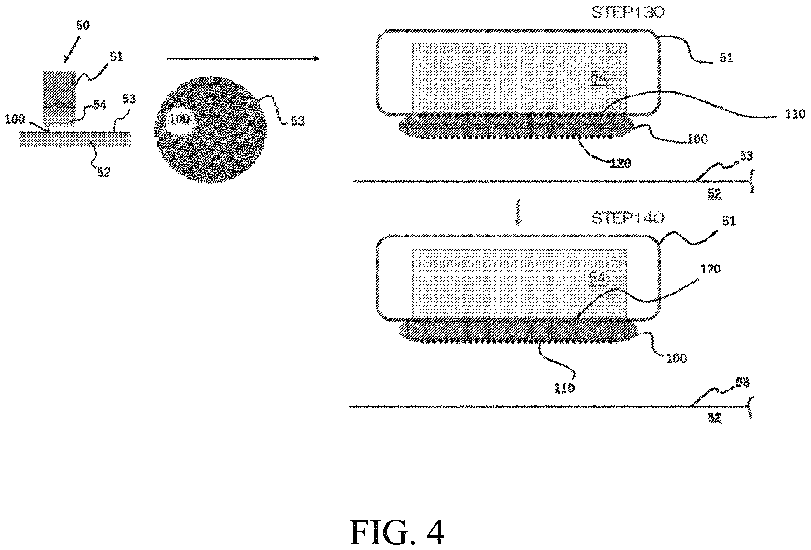

Next, as shown in FIG. 4, in the first surface machining step (STEP 130/FIG. 1), one surface 110 on either side of the cut surface is used as a supporting surface, and the other surface 120 is mechanically polished (high precision grinding).

Specifically, in the first surface machining step (STEP 130/FIG. 1), grinding process is performed by a mechanical polishing device 50 (ultra-high synthetic high-precision grinding device) that performs mechanical polishing.

The mechanical polishing device 50 comprises a spindle 51 and a diamond grindstone 53 located on a platen 52 of a flat plate.

First, one surface 110 of the SiC wafer 100 faces upward and is sucked to and supported by a porous vacuum chuck 54 which is a suction plate of the spindle 51, and the other surface 120 faces downward and is ground with the diamond grindstone 53.

At this time, the spindle 51 and the diamond grindstone 53 are rotationally driven by a driving device (not shown), and the other surface 120 is ground by pressing the spindle 51 against the diamond grindstone 53 using a compressor or the like (not shown).

Here, after the grinding process, the diamond grindstone 53 can be dressed by a dresser or the like.

Furthermore, the mechanical polishing device 50 can have functional water supply piping as necessary, so that multiple types of functional water can be used during the process.

Next, in the second surface machining step (STEP140/FIG. 1), the other surface 120 which has been subjected to the high-precision grinding process in the first surface machining step is directed upward, and the same high-precision grinding process as in the first surface machining step is performed on the one surface 110.

That is, the other side 120 is facing upward and is sucked to and supported by the porous vacuum chuck 54 which is the suction plate of the spindle 51, and the one side 110 is facing downward and is ground with the diamond grindstone 53.

In this case, the dresser or the like can also be pressed against the diamond grindstone 53 to perform dressing as necessary.

According to the mechanical polishing (high-precision grinding) process of the above-mentioned first surface machining step (STEP130/FIG. 1) and second surface machining step (STEP140/FIG. 1), any one surface of the transfer-free cut surface with high flatness obtained in the cutting and polishing step is used as the supporting surface (suction surface), and the other surface is sequentially and mechanically polished (high-precision grinding process). Accordingly, this can prevent so-called transfer and obtain high-quality SiC wafers, and can greatly simplify the conventional loose grinding stone process, which is a complicated manufacturing process containing, for example, multiple times of lapping step (from one time to four times).

More specifically, there is no need to exchange grinding stones for rough grinding and multiple times of fine grinding. For example, it is possible to directly perform a grinding process till fine grinding at once with a #30000 or above grinding stone. Therefore, it is not only simple but also has the advantage of being able to ensure a large amount of usable intrinsic semiconductor layers from the SiC wafer 100.

Here, in the high-precision grinding processing of the first surface machining step (STEP130/FIG. 1) and the second surface machining step (STEP140/FIG. 1), the size of SiC wafer 100 currently reaches 8 inches. However, wafers of various diameters (up to 12 inches) can be set according to the area of the grinding head to perform high-precision grinding processing.

The embodiment of the manufacturing method of the SiC wafer is described in detail above. According to the SiC wafer manufacturing method and device of this embodiment, since the groove machining drum grindstone 20, the polishing pad 30 and the wire saw device 4 have corresponding concave and convex groove shapes, (1) with respect to a plurality of concave grooves 11 formed on the entire side surface of the SiC ingot 10 by the groove machining drum grindstone 20, (2) polishing along the concave grooves 11 can be performed with the polishing pad 30 having exactly the same pitch, and (3) by the wires 42 revolved via the wire saw bobbin 40 having the bobbin grooves 41 having the same shape as the concave grooves 11, the SiC ingot 10 can be cut into slices at once with high precision by using the plurality of wires 41 accurately arranged in the plurality of concave grooves 11. Therefore, high-quality SiC wafers 100 can be manufactured simply and reliably.

In addition, in the above embodiment, the pad groove formation step (STEP 10 / FIG. 1) may be changed so that the pad grooves 31 and the pad convex portions 32 have the same shape as the plurality of concave grooves 11 (plural convex portions 21 of the groove machining drum grindstone 20) surrounding the entire side surface of the SiC ingot 10.

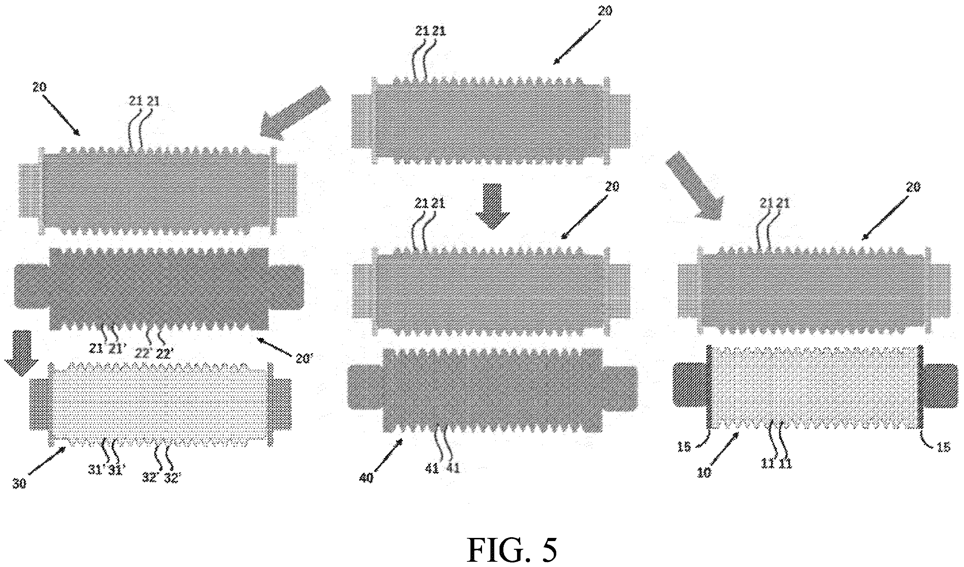

Specifically, as shown in FIG. 5, in the pad groove formation step (STEP 10/FIG. 1), a cylindrical pad groove machining grindstone 20' is prepared in advance, and the groove machining drum grindstone 20 is pressed against the pad groove machining grindstone 20' while the groove machining drum grindstone 20 and the pad groove machining grindstone 20' are rotated on rotation shafts parallel to each other. Thereby, pad machining grooves 21' (pad machining convex portions 22') corresponding to the plurality of convex portions 21 are formed in the pad groove machining grindstone 20'.

Next, while the pad groove machining grindstone 20' and the polishing pad 30 are respectively rotated on rotation shafts parallel to each other, the pad groove machining grindstone 20' is pressed against the polishing pad 30. Thereby, a plurality of pad grooves 31' corresponding to the pad machining grooves 21' (pad machining convex portions 22') are formed on the entire side surface of the polishing pad 30.

Thus, in the grinding step (STEP110/FIG. 1), the polishing performance can be further improved by using the polishing pad 30' to polish the concave grooves 11 with a plurality of pad convex portions 32' that are completely consistent with the plurality of concave grooves 11.

In addition, in the SiC wafer manufacturing method of this embodiment, after the above series of processes, a chemical mechanical polishing (CMP) step, a wafer cleaning step, etc. can be performed as necessary.

Furthermore, this embodiment illustrates the manufacturing method of a semiconductor crystal wafer based on the situation of manufacturing a SiC wafer from a SiC ingot. However, the semiconductor crystal is not limited to SiC, and can also be gallium arsenide, indium phosphide, silicon, and other compound semiconductors.

Furthermore, this embodiment has explained that in the groove machining step (STEP100/FIG. 1), the SiC ingot 10 is supported to be freely rotatable while its two end surfaces are protected by a pair of protective plates 15, 15, but the present disclosure is not limited to as such.

For example, in the groove machining step (STEP100/FIG. 1), it is also possible that the pair of protective plates 15, 15 are omitted and the SiC ingot 10 is directly fix onto the rotation shaft.

Furthermore, steps other than the groove machining step (STEP 100/FIG. 1), for example, the grinding step (STEP110/FIG. 1), the cutting step (STEP120/FIG. 1) and the like, can also be performed in a state where both end surfaces of the SiC ingot 10 are protected by a pair of protective plates 15, 15.

Furthermore, in this embodiment, FIG. 3 illustrates the case where the groove machining step (STEP100/FIG. 1) and the grinding step (STEP110/FIG. 1) are performed simultaneously along the same longitudinal direction, but the present disclosure is not limited to as such.

For example, the groove machining step (STEP 100/FIG. 1) may be performed in the longitudinal direction and the grinding step (STEP 110/FIG. 1) may be performed in the transverse direction at the same time, or conversely, the groove machining step (STEP 100/FIG. 1) may be performed in the transverse direction and the grinding step (STEP 110/FIG. 1) may be performed in the longitudinal direction at the same time. Furthermore, the grinding step (STEP 110/FIG. 1) may be performed after the groove machining step (STEP 100/FIG. 1).

Furthermore, in this embodiment, the SiC ingot 10, the groove machining drum grindstone 20, the polishing pad 30, and the like are arranged in a laying-down state in FIGs. 2, 3, and 5, but the present disclosure is not limited to this arrangement. The SiC ingot 10, the groove machining drum grindstone 20, the polishing pad 30, and the like can also be arranged in an upright state for performing process.

### REFERENCE SIGNS LIST

- 1: SiC crystal (semiconductor crystal)
- 4: wire saw device
- 10: SiC ingot (semiconductor crystal ingot)
- 11: concave groove
- 15: protective plate
- 20: groove machining drum grindstone
- 20': pad groove machining grindstone
- 21: convex portion
- 21': pad machining groove
- 22': pad machining convex portion
- 30: polishing pad
- 31,31': pad groove
- 32,32': pad convex portion
- 40: wire saw bobbin
- 41: bobbin groove
- 42: wire
- 50: mechanical polishing device (ultra-high synthetic high-precision grinding device)
- 51: spindle
- 52: platen
- 53: diamond grindstone
- 54: porous vacuum chuck (suction plate)
- 100: SiC wafer (semiconductor crystal wafer)
- 110: surface
- 120: surface

## Claims

1. A semiconductor crystal wafer manufacturing device which cuts a semiconductor crystal ingot, that has been ground into a cylindrical shape, into slices as wafers, the device comprising:
a groove machining drum grindstone configured for forming a plurality of concave grooves surrounding an entire side surface of said semiconductor crystal ingot, wherein a plurality of convex portions corresponding to the plurality of concave grooves are formed on a side surface of the groove machining drum grindstone;
a polishing pad being cylindrical and configured for polishing the plurality of concave grooves, wherein a plurality of pad grooves corresponding to said plurality of convex portions are formed on an entire side surface of the polishing pad; and
a wire saw device for revolving a plurality of wires arranged in said plurality of concave grooves while advancing the plurality of wires, thereby cutting said semiconductor crystal ingot into slices, and an entire side surface of a wire saw bobbin for revolving the plurality of wires is formed with bobbin grooves corresponding to said plurality of convex portions.

2. The semiconductor crystal wafer manufacturing device of claim 1, further comprising a pair of protective plates for protecting both end surfaces of the semiconductor crystal ingot at least when the plurality of concave grooves surrounding the entire side surface of the semiconductor crystal ingot are formed by said groove machining drum grindstone.

3. A semiconductor crystal wafer manufacturing method which cuts a semiconductor crystal ingot, that has been ground into a cylindrical shape, into slices as wafers, the method comprising:
a groove machining step for forming a plurality of concave grooves surrounding an entire side surface of said semiconductor crystal ingot; and
a cutting step for revolving a plurality of wires arranged in the plurality of concave grooves formed in said groove machining step while advancing the plurality of wires, thereby cutting said semiconductor crystal ingot into slices;
the method performing the following steps before said groove machining step:
a pad groove formation step for forming a plurality of pad grooves corresponding to the plurality of convex portions on an entire side surface of a cylindrical polishing pad by using a groove machining drum grindstone, wherein a plurality of convex portions corresponding to said plurality of concave grooves are formed on a side surface of the groove machining drum grindstone, wherein the groove machining drum grindstone is used by being pressed against the semiconductor crystal ingot in said groove machining step, and the polishing pad is used to polish said plurality of concave grooves formed by the groove machining step; and
a bobbin groove formation step for forming bobbin grooves corresponding to said plurality of convex portions on an entire side surface of a wire saw bobbin which revolves the plurality of wires and is used in said cutting step, by using the groove machining drum grindstone to be used by being pressed against the semiconductor crystal ingot in said groove machining step;
wherein, in said groove machining step, said groove machining drum grindstone is pressed against said semiconductor crystal ingot while the groove machining drum grindstone and the semiconductor crystal ingot respectively rotating on rotation shafts parallel to each other, thereby forming the concave grooves, and the polishing pad which is formed with the pad grooves by said pad groove formation step, is pressed against said semiconductor crystal ingot while the polishing pad and the semiconductor crystal ingot respectively rotating on rotation shafts parallel to each other, thereby polishing the concave grooves;
in said cutting step, said semiconductor crystal ingot is cut into slices by a wire saw having wires respectively arranged in the plurality of bobbin grooves formed by said bobbin groove formation step.

4. The semiconductor crystal wafer manufacturing method of claim 3, wherein in said pad groove formation step, said groove machining drum grindstone is pressed against an entire side surface of a cylindrical pad groove machining grindstone to form pad machining grooves corresponding to said plurality of convex portions, and
said pad groove machining grindstone, in which said pad machining grooves are formed, is pressed against the entire side surface of said polishing pad to form a plurality of pad grooves corresponding to said plurality of convex portions.

5. The semiconductor crystal wafer manufacturing method of claim 3 or 4, wherein said semiconductor crystal ingot is rotatably supported through a pair of protective plates that protect both end surfaces of the semiconductor crystal ingot at least during said groove machining step.
